# EUROPEAN PATENT APPLICATION

(11) **EP 3 490 008 A1**
(43) Date of publication of application: **29.05.2019**
(21) Application number: 17203812.7
(22) Date of filing: 27.11.2017
(51) Int. Cl.: H01L 31/048, H02S 20/10, H02S 20/21, H02S 30/20, H02S 40/36

(54) **PHOTOVOLTAIC MULTILAYER LAMINATE**

(71) Applicant: Nederlandse Organisatie voor toegepast- natuurwetenschappelijk onderzoek TNO, 2595 DA 's-Gravenhage (NL)
(72) Inventor: KLERKS, Stan Anton Willem, 2595 DA 's-Gravenhage (NL); ROOSEN-MELSEN, Dorit Aldegonda, 2595 DA 's-Gravenhage (NL); SPEE, Carolus Isa Maria Antoinius, 2595 DA 's-Gravenhage (NL)
(74) Representative: V.O.

(57) **Abstract**

The invention is directed to a photovoltaic multilayer laminate, to a method for preparing a photovoltaic multilayer laminate, to a method for preparing a photovoltaic roadway, and to a photovoltaic roadway.

The photovoltaic multilayer laminate of the invention comprises multiple flexible photovoltaic foil elements laminated at least to a carrier layer comprising electrical interconnections for said flexible photovoltaic foil elements, wherein said multiple flexible photovoltaic elements are arranged transversely to the longitudinal direction of the laminate, wherein a stretchable or compressible space is provided between each pair of multiple flexible photovoltaic foil elements.

## Description

The invention is directed to a photovoltaic multilayer laminate, to a method for preparing a photovoltaic multilayer laminate, to a method for preparing a photovoltaic roadway, and to a photovoltaic roadway.

Photovoltaic devices are well known in the art. Such devices absorb sunlight and convert it directly into useable electrical energy. A typical photovoltaic cell is a solid-state device in which a junction is formed between adjacent layers of semiconductor materials doped with specific atoms. When light energy or photons strike the semiconductor, electrons are dislodged from the valence band. These electrons, collected by the electric field at the junction, create a voltage that can be put at work in an external circuit. Other types of photovoltaic devices include organic photovoltaics wherein, typically, one or several photoactive materials are sandwiched between two electrodes. Sunlight is absorbed in the photoactive layers composed of donor and acceptor semiconducting organic materials to generate photocurrents. The basic principles that underlie photovoltaic devices are well-known and understood to those skilled in the art.

While solar power generation is a clean method of generating energy, there remains a lack of a cohesive integrated infrastructure that uses solar energy as a power source. In addition, some customers find the appearance of solar panels on roofs unappealing and unattractive.

It would be desirable if solar power generation could be integrated in trafficable surfaces (such as roads, parking lots, driveways, sidewalks and the like), exterior walls of buildings (such as houses), roofs, baffle boards, *etc.*

In recent years, photovoltaic trafficable surfaces have emerged as a solution to increase the amount of energy harvested from the sun. A known photovoltaic trafficable surface is SolaRoad®. This photovoltaic trafficable surface comprises a top layer of tempered glass of about 1 cm thick with underneath crystalline silicon solar cells. The SolaRoad® system is based on the application of rigid sheets of photovoltaic materials which are laminated in a multilayer structure on a rigid substrate (glass or concrete), creating tiles of SolaRoad®. These tiles will all have to be individually electrically connected. The application and construction of these tiles on a road is time and cost expensive, and makes total cost of ownership too expensive for large scale use. Normally, roads are usually constructed by direct deposition on the spot, instead of laying large heavy tiles.

Other solutions have been suggested, such as painting of a solar cell directly on a road. This is, for instance, described in NL-C-1 040 685. Making a durable long-living high efficient solar cell module via this route is, unfortunately, highly complex and cannot be done by direct application.

WO-A-02/50375 describes a method for realising a road construction in which on a foundation layer a binder course with incorporated particles is applied by unwinding it from a roll of a prefabricated bituminised fleece.

WO-A-2014/128475 discloses a mobile solar power plant comprising a retractable flexible solar array structure with a plurality of thin film photovoltaic modules mounted on a flexible substrate, which flexible solar array structure can be rolled. Disadvantage of this system is that it can only be applied linearly and cannot bend with curves.

It would be desirable to have a photovoltaic system that can be applied onto a road from a roll. An important aspect of applying a solar road from a roll of solar panels is how to deal with curves, deformations and differences in the profile of a road. In addition, the electrical connections of a solar road need to be connected in the roll as compared to individual connectors to a tiles solar panel.

Objective of the invention is to address disadvantages of the prior art and/or one or more of these needs.

The inventors surprisingly found that this objective can be met, at least in part, by a photovoltaic multilayer laminate having flexible photovoltaic foil elements.

Accordingly, in a first aspect the invention is directed to a photovoltaic multilayer laminate, comprising multiple flexible photovoltaic foil elements laminated at least to a carrier layer comprising electrical interconnections for said flexible photovoltaic foil elements, wherein said multiple flexible photovoltaic elements are arranged in the laminate plane, transversely to the longitudinal direction of the laminate, wherein a stretchable or compressible space is provided between each pair of multiple flexible photovoltaic foil elements.

The term "flexible" as used in this application with reference to the photovoltaic foil elements is meant to describe the property that, when a local force is applied to the photovoltaic foil elements in a direction generally perpendicular to the plane of the foil, the foil will bend rather than break.

The term "stretchable" as used in this application with reference to the space is meant to describe the property that, when a local force is applied in a direction in the plane of the space material, the space will stretch and become larger. Typically, in the context of this application, the term "stretchable space" refers to a space which can be adjusted by stretching one side thereof by applying a force, while another side thereof remains non-stretched.

The term "compressible" as used in this application with reference to the space is the opposite of "stretchable" and is meant to refer to the property that, when a local force is applied in a direction in the plane of the space material, the space will compress and become smaller. Typically, in the context of this application, the term "compressible space" refers to a space which can be adjusted by compressing one side thereof by applying a force, while another side thereof remains non-compressed.

Whereas state of the art photovoltaic solutions typically apply crystalline silicon rigid solar cells on a sheet, encapsulated in many cases between glass or polymer plates, the invention uses discrete elements of flexible photovoltaic foil laminated between polymer foils. This laminate may be applied to a discrete concrete slab or asphalt paving. A roll of multilayer photovoltaic foil can be applied resulting into hundreds to thousands of metres of photovoltaic road in one piece. The invention can deal with any road width, independent of the width of the produced photovoltaic foil. Furthermore, the photovoltaic multilayer laminate of the invention has a built-in possibility to stretch the laminate which enables to facilitate curves, deformations and differences in the profile of a road.

Suitably, the photovoltaic multilayer laminate is provided with a stretchable space between each pair of multiple flexible photovoltaic foil elements. Leaving a little stretchable space between the flexible photovoltaic foil elements in the laminate allows for applying a curvature. Alternatively or additionally, the stretchable space can be used to absorb any unevenness in an underlying structure, such as a road. Such unevenness may be due to bumps or irregularities, and/or may arise in the course of time.

Curves in roads (in particular horizontal curves in the plane of the road) generally have a relatively large radius of curvature and therefore the stretch does not have to be very large. The spaces can further absorb possible differences in coefficients of thermal expansion.

A stretchable or compressible space can, for instance, be realised by choosing a material for the carrier layer that is stretchable or compressible, *i.e.* that can be stretched or compressed due to its material properties. Another way of realising a stretchable space is, for example, by providing indentations in the carrier which indentations allow for stretching. A compressible space may be realised, for instance, by utilising pre-stretched indentations. Further options include the use of a carrier material with structure which allows for stretching or compressing (*e.g.* meander structure or harmonica structure). For the purpose of the invention, it may be sufficient that the carrier layer is stretchable or compressible at locations in the laminate between each pair of flexible photovoltaic foil elements. At locations where the flexible photovoltaic foil elements are laminated to the carrier layer, the carrier layer may in principle be stiff. A carrier with stiff zones and stretchable or compressible zones can, for example, comprise stiff zones where the carrier layer is not provided with indentations that allow for stretching or compressing, and stretchable or compressible zones with indentations where the carrier layer is provided with indentations that allow for stretching or compressing.

Typically, the stretchable or compressible space allows for adjusting the angle between two adjacent flexible photovoltaic foil elements in the laminate. Preferably, the stretchable or compressible space allows for adjusting the angle between two adjacent flexible photovoltaic foil elements in the laminate from 0° to 10°, such as from 0° to 5 °, from 0° to 4°, from 0° to 3°, from 0° to 2°, or from 0° to 1°.

The stretchable or compressible space between each pair of flexible photovoltaic foil elements may suitably be 5 mm or more, preferably 10 mm or more, such as 15 mm or more. The space between each pair of multiple flexible photovoltaic foil elements may suitably be 50 mm or less, preferably 30 mm or less, such as 25 mm or less.

The flexible photovoltaic foil elements and the stretchable or compressible space have a width, which is defined as the dimension in the longitudinal direction of the laminate. Preferably, the ratio between the average width of the stretchable or compressible space and the average width of the flexible photovoltaic foil elements is in the range of 1:200 - 1:5, such as in the range of 1:100 - 1:10, in the range of 1:50 - 1:10, or in the range of 1:40 - 1:20. In an embodiment, 0.5-20 % of the length of the laminate (dimension in longitudinal direction) is made up by stretchable or compressible space, preferably 1-10 %, such as 2-10 %.

A flexible photovoltaic foil element may comprise one single piece of flexible photovoltaic foil, or may comprise an assembly of two or more individual pieces of flexible photovoltaic foil. It is preferred, however, that the flexible photovoltaic foil element does not have more than five individual pieces of flexible photovoltaic foil, more preferably the flexible photovoltaic foil element does not have more than three individual pieces of flexible photovoltaic foil, even more preferably the flexible photovoltaic foil element does not have more than two individual pieces of flexible photovoltaic foil, and most preferably the flexible photovoltaic foil element has only one single piece of flexible photovoltaic foil. In accordance with the invention, the multiple flexible photovoltaic elements are arranged in the laminate plane, transversely to the longitudinal direction of the laminate.

A single flexible photovoltaic foil element in the laminate may have a width (in the longitudinal direction of the laminate) of 10 mm or more, such as 20 mm or more, 50 mm or more, 100 mm or more, 200 mm or more 300 mm or more, or 400 mm or more. A single flexible photovoltaic foil element in the laminate may have a width of 2000 mm or less, such as 1500 mm or less, 1200 mm or less, 1000 mm or less, 800 mm or less, 600 mm or less, or 500 mm or less. Suitably, each of the single flexible photovoltaic foil elements in the laminate may have a width in the range of 10-2000 mm, such as 20-1500 mm, 50-1200 mm, 100-1000 mm, 200-800 mm, 300-600 mm, or 400-500 mm.

The length of a single flexible photovoltaic foil element in the laminate (in the transverse direction of the laminate) may vary and can typically be determined by the application. When used for a road, the length of a single flexible photovoltaic foil element may, for instance, be approximately equal to the width of the road (or half the width of the road in case each road half is provided with a separate photovoltaic multilayer laminate). For example, the length of a single flexible photovoltaic foil element in the laminate may be 1 m or more, such as 1.5 m or more, 2 m or more, 3 m or more, or 4 m or more. The length of a single flexible photovoltaic foil element in the laminate may be 14 m or less, such as 12 m or less, 10 m or less, 8 m or less, or 6 m or less. Suitably, each of the single flexible photovoltaic foil elements in the laminate may have a length in the range of 1-14 m, such as 1.5-12 m, 2-10 m, 3-8 m, or 4-6 m.

A single flexible photovoltaic foil element preferably has an aspect ratio (longest dimension divided by shortest dimension) of 1.2 or more, preferably 2 or more, more preferably 3 or more, such as 4 or more. Typically, the aspect ratio of 100 or less, preferably 75 or less, more preferably 50 or less, such as 25 or less. Suitably, each of the single flexible photovoltaic foil elements in the laminate may have an aspect ratio in the range of 1.2-100, such as 2-75, 3-50, or 4-25.

The single flexible photovoltaic foil elements are typically thin film photovoltaics. The thickness of the flexible photovoltaic foil elements may be 30 µm or more, preferably 60 µm or more, more preferably 600 µm or more. The thickness of the flexible photovoltaic foil elements may be 3000 µm or less, preferably 1500 µm or less, more preferably 1000 µm or less. Suitably, each of the single flexible photovoltaic foil elements in the laminate may have a thickness in the range of 30-3000 µm, preferably 60-1500 µm, more preferably 600-1000 µm.

Flexible photovoltaic foil materials are known in the art and may, for example, be based on CIGS (Copper, Indium, Gallium and Selenium), amorphous silicon, organic photovoltaics, perovskite, gallium arsenide (GaAs), and the like. Such materials may be provided on a steel support, preferably a stainless steel support or a polymer support (such as polyimide).

The flexible photovoltaic foil elements may comprise one or more selected from the group consisting of a barrier layer (such as a moisture barrier layer), a substrate layer, a photovoltaic layer, a protective layer, an optical coupling layer, and one or more bus bars. Such layers may be combined into a laminate, such as a laminated sandwich to yield the flexible photovoltaic foil elements. Typically, these layers together form a stack. Going from the "structure-facing" or "support-facing" side to the "sun-facing" side of the flexible photovoltaic foil elements, the order of layers (when present) in such as stack may suitably be a barrier layer, a substrate layer, a photovoltaic layer, a barrier layer, and a protective layer. An optical coupling layer can be present between the barrier layer and the protective layer (to couple the barrier layer with the protective layer) or may be present on top of the protective layer (to couple the protective layer with an anti-skid layer to be applied on the flexible photovoltaic foil element).

The barrier layer may be used to protect the photovoltaic layer from contamination species, such as oxygen or water. More than one barrier layer may be included in the flexible photovoltaic foil elements. Any suitable material or combination of materials may be used for the barrier layer. The barrier layer may incorporate an inorganic, an organic compound, or both.

The substrate layer may be used as a flexible support layer to support the photovoltaic layer(s), such as the active layer generating the electrons and the front and back contact layers The substrate layer may typically comprise a metal and/or a polymer. For example, the substrate layer can comprise stainless steel or a polymer like polyimide. Preferably, the substrate layer comprises a conductive foil, such as a steel foil, which acts as an electrode of the cell. The substrate layer is suitably a flexible substrate.

The photovoltaic layer may comprise an active layer, which may be based on CIGS (Copper, Indium, Gallium and Selenium), amorphous silicon, organic photovoltaics, perovskite, gallium arsenide (GaAs), and the like, and an electrically conductive layer below the active layer and the carrier layer and a transparent electrically conductive layer on top of the active layer. The photovoltaic layer may have a layout that provide a series or parallel connection between cell elements.

The protective layer may serve to mechanically support and protect the photovoltaic layer. A flexible photovoltaic foil element may comprise more than one protective layer. The protective layer may also (or in addition) be provided as a layer in the photovoltaic multilayer laminate rather than as a layer in the flexible photovoltaic foil. Preferably, the protective layer is a transparent layer and may comprise a thin, coated flexible glass layer. The term "transparent" as used in this document is meant to refer to layers and materials which allow at least 75 % of visible solar radiation, such as 80-100 % of this radiation to be transmitted to the cell(s). Any suitable glass material may be used, such as soda lime glass, borosilicate glass, low alkali soda lime glass, *etc.* The glass layer may be sufficiently thin, such as having a thickness of 50-500 µm, to provide flexibility. In some cases, the protective barrier can also include a weatherable top sheet or layer on the sun facing side, for protecting the cell(s) from moisture. The top sheet or layer may be a fluoropolymer layer, such as an ethylene-tetrafluoroethylene copolymer (ETFE) top layer or a fluorinated ethylene propylene (FEP) top layer.

The optical coupling layer may serve to improve the optical properties of the photovoltaic foil element i.e. by bridging differences in refractive indexes between the different materials. The optical coupling layer may comprise one or more materials improving the transmission of light from the top of the flexible photovoltaic foil to the photovoltaic layer. Examples of such materials, for instance, include materials with relatively low refractive index, such as a refractive index of less than 1.5, or less than 1.2.

The one or more bus bars may serve to transport the electrons from the photovoltaic material to the electrical system. Bus bars may differ in material (*e.g.* printed track or metal strip) and/or volume (thickness, width) depending on the (maximum) current that has to go through.

In accordance with the invention, the multiple flexible photovoltaic foil elements laminated at least to a carrier layer comprising electrical interconnections for said flexible photovoltaic foil elements. This carrier layer should be stretchable at least over the space between each flexible photovoltaic foil elements. It is practicable, however, when the multiple flexible photovoltaic foil elements are laminated onto a stretchable carrier layer (*viz.* the carrier is stretchable over its entire length). The carrier layer is preferably also flexible so that the entire laminate can be winded on a roll.

The carrier layer in the photovoltaic multilayer laminate comprises electrical interconnections for said flexible photovoltaic foil elements. It is preferred that flexible photovoltaic foil elements are individually connected to a piece of electronics. Hence, the electrical interconnections preferably lead from and/or to the flexible photovoltaic foil elements. The electrical interconnections may also be interconnections between different flexible photovoltaic foil elements such that the elements are connected in series. This is, however, not preferred. Suitably, the carrier layer may be a metal (conductive) sheet or metallic fabrics. It is also possible to provide a plastic material or a fabric of non-conductive material(s) with a strip of conductive contacts. The carrier layer can be a grounded shield for an underlying high voltage structure. The carrier layer can play a role in the barrier functionality and/or mechanical protection for the photovoltaic material. The carrier layer may comprise one or more elements selected from the group consisting of a Maximum Power Point Tracking (MPPT) device, an invertor, a micromodule, an electrical switch for switching between a low voltage part and a high voltage part, a diode, a safety component (such as galvanic separation), battery foil, lighting (such as light emitting diode lighting), heating, and a sensor. A suitable commercial solution that combines MPPT tracking and a diode function is the Maxim chip, of which the size is so small that it can be readily processed in a foil. By integrating electronics in the laminate optimal power output of the photovoltaic system is ensured. Non-stretchable components may be applied at locations of flexible photovoltaic foil elements where no stretching is required. Electrical switches can create a safety barrier between a low, safe voltage part and a high voltage part. Suitably, the carrier layer may comprise one or more electrical insulation layers, one or more flexible direct current-direct current converters, one or more flexible direct current-alternating current converters, one or more conductive tracks (which may be realised, for instance, by meander structures or stretchable metals such as printed silver and/or or copper tracks) both for separated or safety extra-low voltage (SELV) and high voltage, a grounded metal conductive sheet layer, and an adhesive layer.

The photovoltaic multilayer laminate may further comprise one or more selected from the group consisting of an adhesion layer, an anti-skid layer, a damping layer, and an anti-adhesion layer.

An adhesion layer may be used to adhere the multilayer laminate to an underlying support, such as a roadway. Hence, such an adhesion layer is typically applied to a structure-facing or support-facing side of the multilayer laminate. The support may suitably be a concrete or asphalt support. Adhesion layers may typically be based, for instance, on bitumen, modified bitumen, epoxy, acrylate and polyurethane materials.

An anti-skid or anti-slip layer may be used to increase the surface roughness of the multilayer laminate, in particular when the photovoltaic multilayer laminate is to be applied in a photovoltaic roadway. Such an anti-skid layer is thus typically applied to a sun-facing side of the multilayer laminate. The anti-skid layer may further mechanically protect the photovoltaic foil elements. It is also possible to apply an anti-skid or anti-slip layer after installation of the laminate.

Furthermore, the multilayer laminate may comprise a non-adhesive or self-cleaning coating. Such a non-adhesive coating may serve to prevent dirt to adhere onto the photovoltaic multilayer laminate which can reduce photovoltaic efficiency. When dirt should collect on the multilayer laminate, such dirt may be washed off by rain in the presence of such a non-adhesive coating. A non-adhesive coating may therefore typically be applied to a sun-facing side of the multi-layer laminate.

Preferably, the photovoltaic multilayer laminate comprises a multitude of individual flexible photovoltaic foil elements. For example the photovoltaic multilayer laminate may comprise at least 10 flexible photovoltaic foil elements, preferably at least 50 flexible photovoltaic foil elements, more preferably at least 100 flexible photovoltaic foil elements, and even more preferably at least 200 flexible photovoltaic foil elements. The upper limit for the amount of flexible photovoltaic foil elements is not critical, but in practice the photovoltaic multilayer laminate will typically not comprise 1000 flexible photovoltaic foil elements or less.

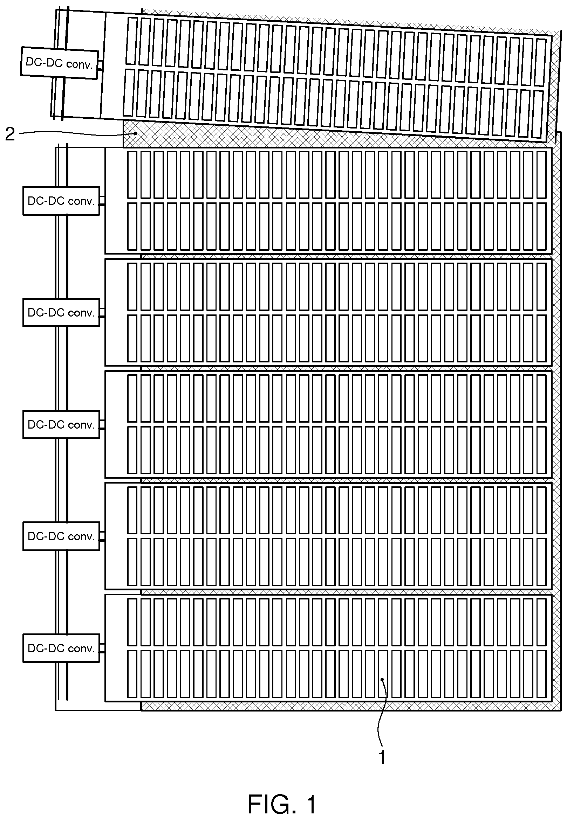

A schematic embodiment of a photovoltaic multilayer laminate of the invention is shown in figure 1. The laminate comprises multiple flexible photovoltaic foil elements 1 that are laminated to an underlying carrier layer with electrical interconnections. Between each pair of multiple flexible photovoltaic foil elements, a space 2 is provided that (in the embodiment of figure 1) can be stretched such that a curvature is realised.

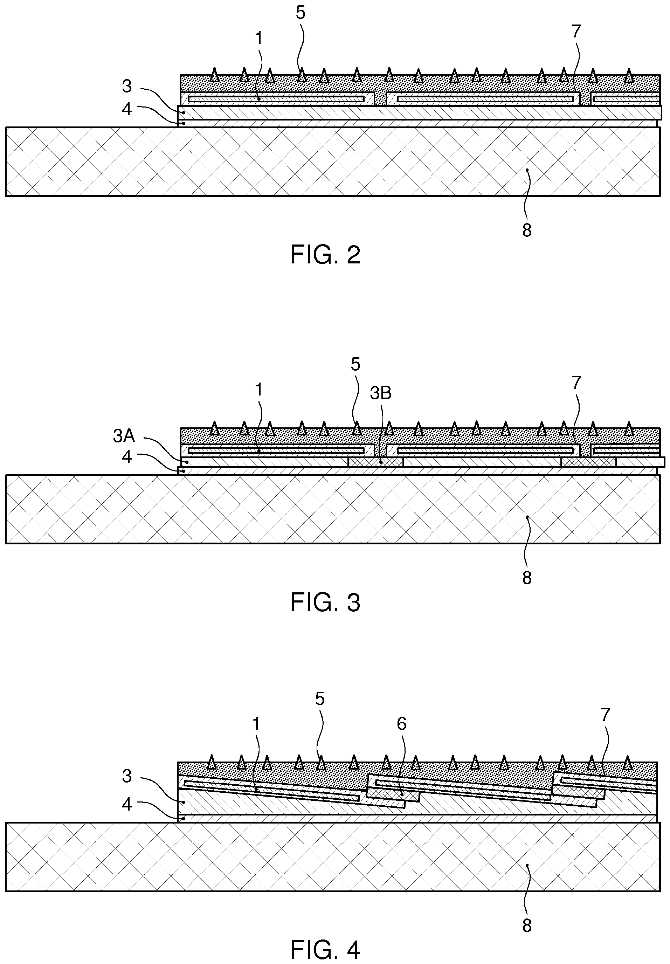

Further schematic embodiments of a photovoltaic multilayer laminate of the invention are shown in figures 2-4. In each of these figures, the laminate comprises multiple flexible foil elements 1 that are laminated to an underlying carrier layer 3. The laminate 7 further has an anti-skid layer 5 and is applied onto a support 8 by an adhesion layer 4. In the schematic embodiment of figure 2, the carrier layer 3 is stretchable or compressible. In the schematic embodiment of figure 3, the carrier layer 3 has rigid parts 3A and stretchable or compressible parts 3B. In the schematic embodiment of figure 4 the space between each pair of multiple flexible photovoltaic is rendered stretchable by using a stretchable adhesive 6.

It is advantageous if the flexible photovoltaic foil elements are obtained by a roll-to-roll process. This allows the production of a continuous supply of flexible photovoltaic foil. This continuous supply of flexible photovoltaic foil may be cut into separate flexible photovoltaic foil elements to approximately the width of a road. Subsequently, multiple flexible photovoltaic foil elements can be laminated onto the carrier layer, transversely to the longitudinal direction of the carrier layer. This results in a multilayer laminate, wherein the individual flexible photovoltaic foil elements are arranged in the plane of the laminate, transversely to the longitudinal direction of the laminate.

A photovoltaic multilayer laminate according to the invention may suitably have a length of 3 m or more, such as 100 m or more, or 150 m or more. The photovoltaic multilayer laminate may suitably have a length of 500 m or less, such as 400 m or less, or 300 m or less. Suitably, the photovoltaic multilayer laminate may have a length in the range of 50-500 m, preferably 100-400 m, more preferably 150-300 m. Multiple photovoltaic multilayer laminates may be connected in series.

Accordingly, in a further aspect the invention is directed to a method for preparing a photovoltaic multilayer laminate, preferably as described herein, comprising preparing a roll of flexible photovoltaic foil, cutting the roll of flexible photovoltaic foil into multiple flexible photovoltaic foil elements, and laminating the multiple flexible photovoltaic foil elements at least to a carrier layer comprising electrical interconnections for said flexible photovoltaic foil elements, wherein the multiple flexible photovoltaic foil elements are laminated onto the carrier layer transversely to the longitudinal direction of the carrier layer, and wherein a stretchable or compressible space is provided between each pair of multiple flexible photovoltaic foil elements.

Preferably, also the carrier layer is supplied on a roll, such as a continuous supply of carrier layer. This allows easy and cost effective manufacture of the multilayer laminate of the invention.

Preferably, the photovoltaic multilayer laminate of the invention is prepared in a production environment, rather than on-site.

Once the photovoltaic multilayer laminate of the invention has been prepared, it may be suitably winded on a roll for storage, transport, and/or future application on-site. Accordingly, in a preferred embodiment, the method for preparing a photovoltaic multilayer laminate further comprises winding the obtained photovoltaic multilayer laminate on a roll.

In yet a further aspect, the invention is directed to a method for preparing a photovoltaic roadway comprising the step of applying a photovoltaic multilayer laminate according to the invention onto a roadway. As previously mentioned, such step advantageously comprises unwinding the photovoltaic multilayer laminate from a roll.

Applying the photovoltaic multilayer laminate from a roll advantageously limits the installation activities on-site. Additionally, installation time is reduced and product quality can be kept high.

In certain instances, the roadway onto which the photovoltaic multilayer laminate is to be applied will not be completely straight, but will have some degree of curvature. Such curvature may be a curvature in the plane of the roadway (*viz.* a horizontal curvature of the roadway or a bend in the roadway), but may also be a curvature out of the plane of the roadway (*viz.* a vertical curvature of the roadway or a slope in the roadway). Also, combinations of the above may occur. In such cases, the photovoltaic multilayer laminate will have to be applied along the curvature. Accordingly, the method for preparing a photovoltaic roadway may comprise a step of applying a curvature in the photovoltaic multilayer laminate by stretching or compressing the laminate along a curve of the roadway. It is preferred that in such cases the photovoltaic multilayer laminate comprises an adhesion layer which aids maintaining the laminate fixed at its location, and to reduce or prevent possible displacement of the laminate with respect to the underlying roadway. Another, or additional, option is to glue the photovoltaic multilayer laminate onto the underlying roadway.

Once applied onto the roadway, the photovoltaic system can be electrically connected.

In yet a further aspect, the invention is directed to a photovoltaic roadway comprising a photovoltaic multilayer laminate according to the invention.

The invention has been described by reference to various embodiments, and methods. The skilled person understands that features of various embodiments and methods can be combined with each other.

All references cited herein are hereby completely incorporated by reference to the same extent as if each reference were individually and specifically indicated to be incorporated by reference and were set forth in its entirety herein.

The use of the terms "a" and "an" and "the" and similar referents in the context of describing the invention (especially in the context of the claims) are to be construed to cover both the singular and the plural, unless otherwise indicated herein or clearly contradicted by context. The terms "comprising", "having", "including" and "containing" are to be construed as open-ended terms (*i.e.,* meaning "including, but not limited to") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. The use of any and all examples, or exemplary language (*e.g.,* "such as") provided herein, is intended merely to better illuminate the invention and does not pose a limitation on the scope of the invention unless otherwise claimed. No language in the specification should be construed as indicating any non-claimed element as essential to the practice of the invention. For the purpose of the description and of the appended claims, except where otherwise indicated, all numbers expressing amounts, quantities, percentages, and so forth, are to be understood as being modified in all instances by the term "about". Also, all ranges include any combination of the maximum and minimum points disclosed and include any intermediate ranges therein, which may or may not be specifically enumerated herein.

Preferred embodiments of this invention are described herein. Variation of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject-matter recited in the claims appended hereto as permitted by applicable law. Moreover, any combination of the above-described elements in all possible variations thereof is encompassed by the invention unless otherwise indicated herein or otherwise clearly contradicted by context. The claims are to be construed to include alternative embodiments to the extent permitted by the prior art.

For the purpose of clarity and a concise description features are described herein as part of the same or separate embodiments, however, it will be appreciated that the scope of the invention may include embodiments having combinations of all or some of the features described.

The invention will now be further illustrated by means of the following examples, which are not intended to limit the scope in any manner.

## Claims

1. Photovoltaic multilayer laminate, comprising multiple flexible photovoltaic foil elements laminated at least to a carrier layer comprising electrical interconnections for said flexible photovoltaic foil elements, wherein said multiple flexible photovoltaic elements are arranged in the laminate plane, transversely to the longitudinal direction of the laminate, wherein a stretchable or compressible space is provided between each pair of multiple flexible photovoltaic foil elements.

2. Photovoltaic multilayer laminate according to claim 1, wherein the angle between two adjacent multiple flexible photovoltaic foil elements in the laminate is adjustable by means of the stretchable or compressible space, preferably in the range of from 0° to 10°, such as from 0° to 5 °, from 0° to 4°, from 0° to 3°, from 0° to 2°, or from 0° to 1°.

3. Photovoltaic multilayer laminate according to claims 1 or 2, wherein the ratio between the average width of the stretchable or compressible space and the average width of the flexible photovoltaic foil elements is in the range of 1:200 - 1:5, such as in the range of 1:100 - 1:10, in the range of 1:50 - 1:10, or in the range of 1:40 - 1:20.

4. Photovoltaic multilayer laminate according to any one of claims claim 1-3, wherein said space is 5-50 mm wide, preferably 10-30 mm, such as 15-25 mm.

5. Photovoltaic multilayer laminate according to any one of claims 1-4, wherein each flexible photovoltaic foil element in the laminate has a width of 10-2000 mm, such as 20-1500 mm, 50-1200 mm, 100-1000 mm, 200-800 mm, 300-600 mm, or 400-500 mm.

6. Photovoltaic multilayer laminate according to any one of claims 1-5, wherein said flexible photovoltaic foil elements have a thickness in the range of 30-3000 µm, preferably 60-1500 µm, more preferably 600-1000 µm.

7. Photovoltaic multilayer laminate according to any one of claims 1-6, wherein said flexible photovoltaic foil elements comprise one or more selected from the group consisting of a barrier layer, a photovoltaic layer, a carrier layer, optical coupling layer, one or more bus bars, and a protective layer.

8. Photovoltaic multilayer laminate according to any one of claims 1-7, further comprising one or more selected from the group consisting of an adhesion layer, an anti-skid layer, a damping layer, and an anti-adhesion layer.

9. Photovoltaic multilayer laminate according to any one of claims 1-8, wherein said laminate comprises at least 10 flexible photovoltaic foil elements, preferably at least 50 flexible photovoltaic foil elements, more preferably at least 100 flexible photovoltaic foil elements, and even more preferably at least 200 flexible photovoltaic foil elements.

10. Photovoltaic multilayer laminate according to any one of claims 1-9, wherein said carrier layer further comprises one or more selected from the group consisting of a Maximum Power Point Tracking (MPPT) device, an invertor, and an electrical switch for switching between a low voltage part and a high voltage part, a diode, a safety component, battery foil, lighting, heating, and a sensor.

11. Photovoltaic multilayer laminate according to any one of claims 1-10, wherein said flexible photovoltaic foil elements are obtained by a roll-to-roll process.

12. Method for preparing a photovoltaic multilayer laminate according to any one of claims 1-11, comprising preparing a roll of flexible photovoltaic foil, cutting the roll of flexible photovoltaic foil into multiple flexible photovoltaic foil elements, and laminating the multiple flexible photovoltaic foil elements at least onto a carrier layer comprising electrical interconnections for said flexible photovoltaic foil elements, wherein the multiple flexible photovoltaic foil elements are laminated onto the carrier layer transversely to the longitudinal direction of the carrier layer, and wherein a stretchable or compressible space is provided between each pair of multiple flexible photovoltaic foil elements.

13. Method for preparing a photovoltaic roadway comprising the step of applying, preferably by unwinding it from a roll, a photovoltaic multilayer laminate according to any one of claims 1-11 onto a trafficable surface, an exterior wall of a building, a roof, a baffle board, preferably onto a roadway.

14. Method according to claim 13, wherein said method comprises applying a curvature in the photovoltaic multilayer laminate by stretching or compressing the laminate along a curve of the roadway.

15. Photovoltaic roadway comprising a photovoltaic multilayer laminate according to any one of claims 1-11.
